(19) Europäisches Patentamt

European Patent Office

Office européen des brevets

(11) **EP 4 124 911 A1**

(12) **EUROPEAN PATENT APPLICATION**

(43) Date of publication:
**01.02.2023 Bulletin 2023/05**

(21) Application number: **21188484.6**

(22) Date of filing: **29.07.2021**

(51) International Patent Classification (IPC):
**G03F 7/20** (2006.01)

(52) Cooperative Patent Classification (CPC):
**G03F 7/70633; G03F 7/70641**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **TENNER, Vasco Tomas**
**5500 AH Veldhoven (NL)**

• **CRAMER, Hugo Augustinus Joseph**
**5500 AH Veldhoven (NL)**
• **TUKKER, Teunis Willem**
**5500 AH Veldhoven (NL)**
• **VAN DE VEN, Bastiaan Lambertus Wilhelmus Marinus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND METROLOGY DEVICE**

(57) Disclosed is a metrology device operable to measure a sample with measurement radiation and associated method. The metrology device comprises: an illumination branch operable to propagate measurement radiation to a sample, a detection branch operable to propagate one or more components of scattered radiation, scattered from said sample as a result of illumination of the sample by said measurement radiation; and a dispersive arrangement in either of said illumination branch or said detection branch. The dispersive arrangement is arranged to maintain one or more components of said scattered radiation at substantially a same respective location in a detection pupil plane over a range of wavelength values for said measurement radiation.

Fig. 6

**Description**

FIELD

The present invention relates to a metrology method and device suitable for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

A metrology device may use computationally retrieved phase to apply aberration correction to an image captured by the metrology device. Such metrology devices are described as using coherent or partially coherent illumination. It would be desirable to use incoherent radiation in such a device; however this requires a much larger illumination NA.

SUMMARY

Embodiments of the invention are disclosed in the claims and in the detailed description.

In a first aspect of the invention there is provided a metrology device operable to measure a sample with measurement radiation, the metrology device comprising: an illumination branch operable to propagate measurement radiation to a sample; a detection branch operable to propagate one or more components of scattered radiation, scattered from said sample as a result of illumination of the sample by said measurement radiation; and a dispersive arrangement in either of said illumination branch or said detection branch, wherein said dispersive arrangement is arranged to maintain one or more components of said scattered radiation at substantially a same respective location in a detection pupil plane over a range of wavelength values for said measurement radiation.

In a second aspect of the invention there is provided a method of measuring a sample with measurement radiation, the method comprising: propagating measurement radiation to the sample; capturing one or more components of scattered radiation, scattered from said sample as a result of illumination of the sample by said measurement radiation; and dispersing said measurement radiation or said scattered radiation so as to maintain one or more components of said scattered radiation at substantially a same respective location in a detection pupil plane over a range of wavelength values for said measurement radiation.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6(a) comprises a schematic diagram of a metrology device for use in measuring targets according to embodiments of the invention; and (b) a flow diagram illustrating propagation through the illumination branch of the metrology device of Figure 6(a);
- Figure 7(a) a flow diagram illustrating propagation through the illumination branch of an alternative metrology device comprising a prism in the illumination branch and (b) an alternative prism arrangement; and
- Figure 8 depicts a block diagram of a computer system for controlling a system and/or method as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

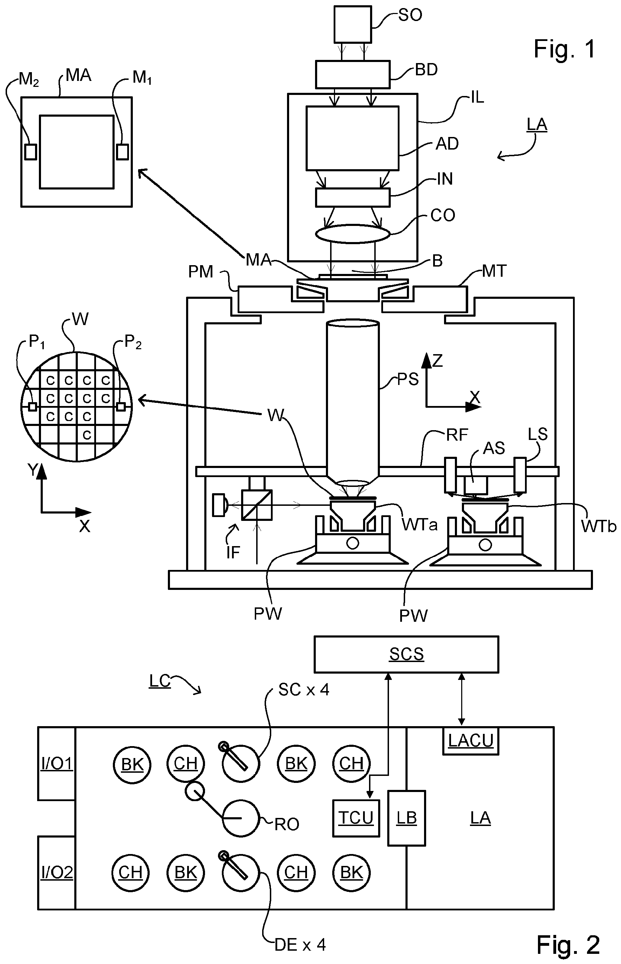

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

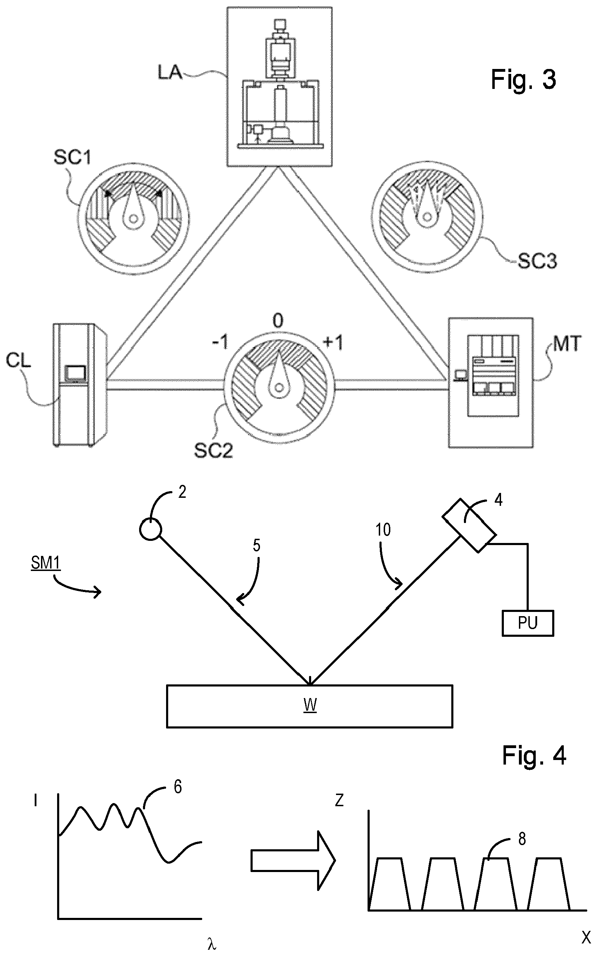

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

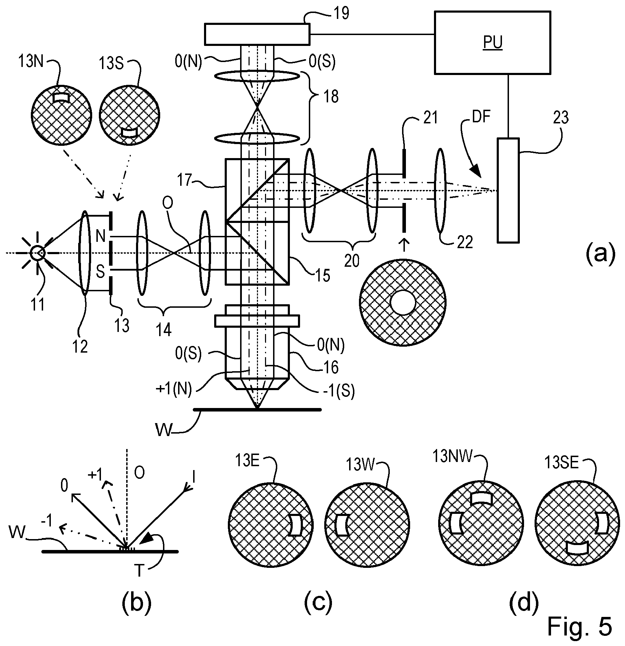

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

The metrology tool just described requires low aberrations (for good machine-to-machine matching for example) and a large wavelength range (to support a large application range for example). Machine-to-machine matching depends (at least partly) on aberration variation of the (microscope) objective lenses being sufficiently small, a requirement that is challenging and not always met. This also implies that it is essentially not possible to enlarge the wavelength range without worsening the optical aberrations. Furthermore, the cost of goods, the volume and/or the mass of a tool is substantial, limiting the possibility of increasing the wafer sampling density (more points per wafer, more wafers per lot) by means of parallelization by providing multiple sensors to measure the same wafer simultaneously.

To address at least some of these issues, a metrology apparatus which employs a computational imaging/phase retrieval approach has been described in US patent publication US2019/0107781, which is incorporated herein by reference. Such a metrology device may use relatively simple sensor optics with unexceptional or even relatively mediocre aberration performance. As such, the sensor optics may be allowed to have aberrations, and therefore produce a relatively aberrated image. Of course, simply allowing larger aberrations within the sensor optics will have an unacceptable impact on the image quality unless something is done to compensate for the effect of these optical aberrations. Therefore, computational imaging techniques are used to compensate for the negative effect of relaxation on aberration performance within the sensor optics.

In such an approach, the intensity and phase of the target is retrieved from one or multiple intensity measurements of the target. The phase retrieval may use prior information of the metrology target (e.g., for inclusion in a loss function that forms the starting point to derive/design the phase retrieval algorithm). Alternatively, or in combination with the prior information approach, diversity measurements may be made. To achieve diversity, the imaging system is slightly altered between the measurements. An example of a diversity measurement is through-focus stepping, i.e., by obtaining measurements at different focus positions. Alternative methods for introducing diversity include, for example, using different illumination wavelengths or a different wavelength range, modulating the illumination, or changing the angle of incidence of the illumination on the target between measurements. The phase retrieval itself may be based on that described in the aforementioned US2019/0107781, or in patent application EP3480554 (also incorporated herein by reference). This describes determining from an intensity measurement, a corresponding phase retrieval such that interaction of the target and the illumination radiation is described in terms of its electric field or complex-valued field ("complex" here meaning that both amplitude and phase information is present). The intensity measurement may be of lower quality than that used in conventional metrology, and therefore may be out-of-focus as described. The described interaction may comprise a representation of the electric and/or magnetic field immediately above the target. In such an embodiment, the illuminated target electric and/or magnetic field image is modelled as an equivalent source description by means of infinitesimal electric and/or magnetic current dipoles on a (e.g., two-dimensional) surface in a plane parallel with the target. Such a plane may, for example be a plane immediately above the target, e.g., a plane which is in focus according to the Rayleigh criterion, although the location of the model plane is not critical: once amplitude and phase at one plane are known, they can be computationally propagated to any other plane (in focus, out of focus, or even the pupil plane). Alternatively, the description may comprise a complex transmission of the target or a two-dimensional equivalent thereof.

The phase retrieval may comprise modeling the effect of interaction between the illumination radiation and the target on the diffracted radiation to obtain a modelled intensity pattern; and optimizing the phase and amplitude of the electric field/complex-valued field within the model so as to minimize the difference between the modelled intensity pattern and the detected intensity pattern. More specifically, during a measurement acquisition, an image (e.g., of a target) is captured on detector (at a detection plane) and its intensity measured. A phase retrieval algorithm is used to determine the amplitude and phase of the electric field at a plane for example parallel with the target (e.g., immediately above the target). The phase retrieval algorithm uses a forward model of the sensor (e.g. aberrations are taken into account), to computationally image the target to obtain modelled values for intensity and phase of the field at the detection plane. No target model is required. The difference between the modelled intensity values and detected intensity values is minimized in terms of phase and amplitude (e.g., iteratively) and the resultant corresponding modelled phase value is deemed to be the retrieved phase. Specific methods for using the complex-valued field in metrology applications are described in PCT application PCT/EP2019/052658, also incorporated herein by reference.

However the illuminated computational imaging based metrology sensor such as described in the aforementioned publications is (mainly) designed for use with spatially coherent, or partially spatially coherent radiation. This results in the following drawbacks:

- The optical crosstalk performance is severely impacted by the fact that the (partial) coherent point spread function is substantial larger than the (near) incoherent point spread function. This limits the process variation performance due to the impact of variations in neighboring customer structures on the measured intensity asymmetry of the metrology target (e.g., from which overlay or focus is inferred). Also of note is that for a given identical detection NA, the incoherent resolution (limit) is twice as good as the coherent resolution (limit), which is (from a different but related viewpoint) also beneficial to reduce optical crosstalk.

- An (iterative) phase retrieval is required which requires a substantial amount of computational hardware, which increases the overall cost of goods of the metrology sensor. Also the phase retrieval is based on multiple diversity measurements, to provide the necessary information needed to retrieve the phase. It is estimated that practically speaking 2 to 10 diversity measurements are needed, increasing sensor acquisition time and/or complexity. For example, the diversity may be obtained by performing measurements sequentially at multiple focus levels. Obtaining stepwise defocused images is therefore slow, resulting in a slow measurement speed and low throughput. A simple calculation demonstrates this. Assuming that 5 through-focus images are taken for each combination of 4 (angular) directions and 5 (sequentially captured) wavelengths, and each image takes 1ms to capture, it will take about 100ms to measure each target. This does not include the time taken for moving the stages and switching wavelengths. In addition, the phase retrieval calculation (which is typically iterative) itself can be computationally intensive and take a long time to converge to a solution.

- Because, for a coherent illuminated computational imaging based metrology sensor, the detection NA (numerical aperture) is larger than the illumination NA, it is required to have a switchable illuminator which allows sequential measurement of the +1st and -1st diffraction orders for an x-target and y-target (hence the ability to switch between four illumination modes). In particular, darkfield imaging requires this, as the images of the +1st and -1st diffraction order can end up being located on top of one another for specific $\lambda/P$ ratios. The alternative (which would not require a switchable illuminator) of having one (low NA) coherent illuminator and four (large NA) detection pupils, does not fit in the available k-space /pupil space/Fourier space/ solid angular space (the terms can be used synonymously) for the desired range of $\lambda/P$ ratios. This increases the complexity, volume and cost of goods of the illumination, which is a disadvantage if one wants to parallelize multiple sensors to increase wafer sampling density. An additional drawback of this sequential measurement of the +1st and -1st diffraction orders, is that the sensor is not insensitive for (spatial average) temporal dose variations of the illumination source.

To address these issues, it is proposed to use a spatial incoherent or a close approximation (or at least multimode) illuminated computational imaging based metrology sensor. Such a metrology sensor may be a darkfield metrology sensor, e.g., for the measurement of asymmetry and parameters derived therefrom such as overlay and focus. For the remaining description, the term incoherent illumination will be used to describe spatially incoherent illumination or a close approximation thereof.

There are two conditions/assumptions under which monochromatic image formation may be assumed to be spatially incoherent; these two conditions/assumptions are:

$$\bar{O}\left(k_x', k_y', k_x, k_y\right) = \bar{O}\left(k_x' - k_x, k_y' - k_y\right)$$

$$\lim_{\mathcal{K} \to \mathbb{R}^2} \iint_{\mathcal{K}} \exp\left(i \frac{2\pi}{\lambda} \begin{bmatrix} k_x \\ k_y \end{bmatrix}^{\mathrm{T}} \cdot \begin{bmatrix} x' - x'' \\ y' - y'' \end{bmatrix}\right) dk_x, dk_y = \delta(x' - x'', y' - y'')$$

where $k_x$, $k_y$ are the x and y parameters in pupil space (k space), $\bar{O}(k_x, k_y)$ denotes the angular spectrum representation of the object (scalar) electric field function $O(x, y)$, $\lambda$ is the wavelength, $\iint_\kappa dk_x, dk_y$ denotes the integration over the Kohler type illumination pupil $\kappa$ and $\delta$ denotes the Dirac delta function. Note that in practice the illumination spatial coherence length will be larger than zero, i.e. the illuminator is not of the ideal Kohler type, but the above assumptions are still valid/made in that case also, to result in a computational model of the (near) spatial incoherent image formation. Note in case of non-monochromatic illumination, an extension of this incoherent imaging formalism is possible under a third assumption, which is that the target response does not (significantly) depend on the wavelength.

An additional benefit of using spatial incoherent illumination (or close approximation), is it enables the possibility of using an extended source, e.g., with a finite bandwidth; the use of a laser like source is not mandatory, as it practically would be for a spatial coherent illumination.

If the illumination numerical aperture (NA) (where the illumination NA characterizes the range of angles over which the system can emit light) is sufficiently larger than the detection numerical aperture (where the detection NA characterizes the range of angles over which the system can accept light), then the diffracted near-field of the target is effectively incoherent. As such, in an embodiment, the illumination NA may be set to be equal or (e.g., slightly) larger than the detection NA. Slightly larger may be up to 5% larger, up to 10% larger, up to 15% larger or up to 20% larger, for example. The pupil space may be shared by two pairs of diffraction orders (and therefore two incident illumination angular directions), one per direction to enable simultaneous detection in X and Y.

It may be difficult to implement different target/structure pitches and/or different illumination wavelengths with such an arrangement while suppressing the optical cross talk from structures. One method which has been proposed to accommodate different pitches and/or wavelengths is to vary the position of the illumination pupil (or detection pupil) dependent on a $\lambda$/P ratio of the illumination wavelength $\lambda$ (where $\lambda$ equals the central wavelength for example in case of a illumination bandwidth which is not small) and target pitch P, so as to ensure at least one component of interest of the scattered radiation, e.g., one or two pairs of complementary higher diffraction orders (e.g., the +1 order and -1 order), coincide in pupil space (Fourier space or k-space) with the (e.g., fixed) detection NA.

A problem with a configurable aperture or illumination NA is the need to reconfigure the aperture each time the illumination wavelength is switched. When measuring a target with multiple (e.g., sequential) wavelengths, the wavelength switching speed should be very high (e.g., below 1ms) to maximize throughput, and hence the illumination aperture would need to be reconfigured prohibitively fast. This issue is not so relevant when the target pitch changes, as this by definition means that a different target is being measured and the time it takes to move to a new target is typically longer than the time required to reconfigure the illumination aperture. As such, it is preferable to keep the (intermediate) illumination NA fixed

To address this issue, it is proposed to provide a dispersive arrangement in either a pupil plane (or conjugate thereof, the term "pupil plane" encompassing any such conjugate where it is appropriate) of an illumination branch (i.e., between illumination source and target) or detection branch (i.e., between target and detector) of a metrology system having a fixed illumination NA and detection NA. The dispersive arrangement displaces the illumination beam or scattered beam (e.g., diffracted beam) in said pupil plane with a change of wavelength such that at least one component within the scattered radiation (e.g., at least a pair of complementary diffraction orders) are captured within the detection NA.

The detection NA describes the angles at which the detection system can receive light. In many rotationally symmetric systems, the detection NA defines the largest angle that is captured with respect to the "optical axis". This optical axis may be chosen to be the rotation axis. For example, the optical axis may be defined as going through the center of the detection aperture stop (in the pupil plane), e.g., where the aperture stop is embodied by detection mirrors as will be described below, or otherwise.

As such, disclosed herein is a metrology device operable to measure a sample with measurement radiation, the metrology device comprising: an illumination branch operable to propagate measurement radiation to a sample; a detection branch operable to propagate one or more components of scattered radiation, scattered from said sample as a result of illumination of the sample by said measurement radiation; and a dispersive arrangement in either of said illumination branch or said detection branch of the metrology device, wherein said dispersive arrangement is arranged to maintain one or more components of the scattered radiation at substantially a same respective location in a detection pupil plane over a range of wavelength values for said measurement radiation.

The range of wavelength values may comprise a range having a lower bound of 200nm, 300nm or 400nm and higher bound of 700nm, 800nm, 1500nm or 2000nm for example (i.e., any combination of one of one of these lower bounds with one of these higher bounds).

In an embodiment, the dispersive arrangement comprises at least one passive dispersive element in the illumination branch, such that wavelength switching may be implemented essentially instantly, without any move and settle time of optomechanical elements in the illumination branch. As such, the dispersive arrangement may comprise the at least one passive dispersive element and at least one lens element so as to displace the illumination beam in said pupil plane with a change of wavelength such that each component of interest in the scattered radiation (e.g., one or more 1st diffraction orders) is maintained at substantially a same respective location in the pupil plane during the wavelength change. Other arrangements may have multiple (e.g., a pair of passive dispersive elements, optionally a pair per illumination beam) arranged to displace the illumination beam as described without a lens element.

In the context of this disclosure, the term dispersive element is used in its widest meaning to include any optical element which separates out wavelength components from multiple wavelength input radiation. This includes a diffractive optical element which may separate out wavelengths via diffraction (i.e., each diffraction order has a diffraction angle dependent on wavelength) or a dispersive element such as a prism or similar element which disperses continuously over the input wavelength band.

The dispersive element or dispersive arrangement may be configurable to match the dispersion of the target. As has been stated, this can be implemented mechanically as the time it takes to move to a new target will be typically longer than the time to reconfigure the dispersive arrangement even when so implemented.

The dispersive element may comprise any diffractive optical element, such as a (e.g., fixed) diffraction grating. To enable configurability for target pitch, a plurality of such fixed gratings may be provided such that a different grating can be switched into the illumination path depending on the target pitch. As an alternative to a fixed grating or plurality thereof, the dispersive element may comprise any form of adjustable diffractive optical element having an adjustable effective pitch, such as an adjustable grating element or an adjustable pitch modulation element. Such an adjustable pitch modulation element may comprise, for example, an acousto-optical modulator AOM (which may be also referred to as an acousto-optical deflector (AOD) or Bragg cell), electro-optical modulator EOM or spatial light modulator (SLM). In another alternative, the dispersive element or arrangement may comprise at least one prism (e.g., a prism or pair of prisms per measurement direction) or other dispersive element made of a dispersive material such as glass, for example.

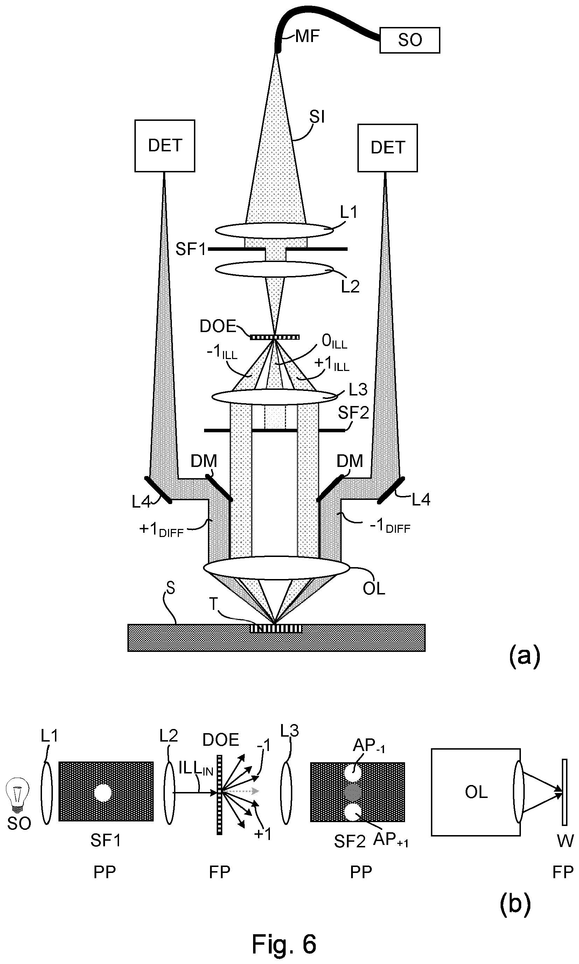

Figure 6(a) is a schematic illustration of a metrology tool or microscope according to an embodiment, which uses using a diffractive optical element DOE as a dispersive element. Note that this is a simplified representation and the concepts disclosed may be implemented in a metrology tool such as illustrated in Figure 5 (also a simplified representation), for example. Figure 6(b) illustrates a schematic detail of propagation through the illumination branch of the system of Figure 6(a).

An illumination source SO, which may be an extended and/or multi-wavelength source, provides source illumination SI (e.g., via a multimode fiber MF). An optical system, e.g., represented here by lens L1, L2 provides access to a pupil plane PP (Fourier plane) or conjugate thereof, at which a spatial filter or mask SF1 which is located to define a (e.g., fixed) intermediate illumination numerical aperture for providing input radiation $ILL_{IN}$. This mask SF1 may comprise a single aperture which is imaged by lens L2 onto the diffractive optical element DOE in a field plane FP. The diffractive optical element DOE may be a grating or modulator element (e.g., an AOM or EOM). The diffractive optical element DOE may have optimal diffraction efficiency for the first orders (e.g., to optimize diffraction efficiency equally for the positive and negative first orders $+1_{ILL}$, $-1_{ILL}$). Where the diffractive optical element DOE is a grating, it may be mounted in a filter wheel, filter strip, filter cassette/carousel or similar arrangement, allowing an appropriate grating to be switched in for a given target pitch.

A further lens system, e.g., represented here by lens L3 and objective lens OL provides access to a pupil plane PP of the objective lens or a conjugate thereof. At least one illumination lens (e.g., a common illumination lens for both beams of measurement radiation $+1_{ILL}$, $-1_{ILL}$ or one illumination lens per beam) may be used instead of the objective lens to focus the illumination beam onto the target T should the objective lens be used only for collecting the scattered radiation and not be comprised in the illumination path). In this pupil plane PP, a second spatial filter SF2 or mask may be used to filter out unwanted diffraction orders (i.e., radiation in the wrong regions of the pupil), passing only the positive and negative first orders $+1_{ILL}$, $-1_{ILL}$ via respective apertures $AP_{+1}$, $AP_{-1}$.

The diffractive optical element generates at least one beam, for example two beams, of measurement radiation at a location in an illumination pupil plane which varies with wavelength of the measurement radiation. As such, each of the illumination diffraction orders $+1_{ILL}$, $-1_{ILL}$ can be used to illuminate the target T on substrate S from a respective opposing direction. As such, the optical system (e.g., objective lens OL) projects and focuses each order $+1_{ILL}$, $-1_{ILL}$ simultaneously onto the target T. The diffracted radiation $+1_{DIFF}$, $-1_{DLFF}$ is guided by detection mirrors DM and lenses L4 to cameras/detectors DET (which may comprise one camera per diffracted order or a single camera or any other arrangement). As such, the detection aperture stop (and therefore detection NA and position) is defined in such an exemplary arrangement by the area and position of detection mirrors DM. In the context of this disclosure, detection aperture stop describes any arrangement which defines the detection NA and position (e.g., one or more detection regions in a pupil plane).

Simultaneously measuring both the +1st and -1st diffraction orders $+1_{DIFF}$, $-1_{DIFF}$ for either or both of an X-target and Y-target has the benefit that intensity noise and wavelength noise (e.g. mode hopping) is easier to suppress, and is highly likely to be better suppressed.

In such an arrangement the illumination profile may be such that the diffracted orders $+1_{DIFF}$, $-1_{DIFF}$ from the target are aligned with and substantially captured by the detection mirrors (e.g., one order per mirror); i.e., the position of +1 and -1 diffraction orders correspond and align with the detection pupil defined by the detection mirrors in pupil space. In an embodiment, the overlapping/alignment of the +1 and -1 orders may be such that the whole of the orders overlap the detection NA (e.g., and are captured by the detection mirrors). In other embodiments, it may be at least 95%, at least 90%, at least 80% or at least 70 % of the +1 and -1 orders overlap the detection NA (e.g., and are captured by the detection mirrors or more generally the detection aperture stop). Of particular relevance is that the full detection region is filled with the corresponding diffraction order (assuming an infinitely large target, so that the diffraction order forms a Dirac delta function in angular space, i.e. in the detection pupil space). This is similar to a summation over the Kohler illuminator in the equation above. It is desirable that all angles which can propagate are present. As angular space is limited to 1 [sine-angle] (i.e. an angle of 90 degrees) it is not possible to sum from $-\infty$ to $+\infty$, which would be ideal from a mathematical point of view.

To cover sufficiently high $\lambda/\rho$ values, e.g., at least up to 1.3, the detection pupil apertures may be located at a high NA, and the centers of the Y-OV detection apertures may be at least 0.65 from the Y-axis and similarly, the enters of the X-OV detection apertures may be at least 0.65 from the X-axis.

In this embodiment, the dispersive arrangement which displaces the illumination beams $+1_{ILL}$, $-1_{ILL}$ in said pupil plane according to wavelength such that the 1st diffraction orders $1_{DIFF}$, $-1_{DIFF}$ are maintained at substantially the same respective location in the pupil plane comprises the diffractive optical element and lens L3 (or other suitable optical element).

The diffractive optical element or grating may have pitch $p_{ill}$. This creates diffraction orders at angles $\frac{\lambda}{p_{ill}}$, where $\lambda$ is the illumination wavelength. The pitch $p_{ill}$ may be matched to the pitch of the overlay target $p$ according to $p_{ill} = p * M$, where $M$ is the magnification of the microscope. In order to match the grating to the pitch of the target, gratings with several pitches can be placed on a disk (or other arrangement), and rotated to select the desired grating.

The advantages of using a grating as a dispersive element for generating the illumination beams according to the concepts disclosed is that:

- The arrangement provides an instantly programmable illuminator.
- The dispersion is naturally matched to target.
- A single illumination pupil is split into to two similar illumination pupils (i.e., two complementary diffraction orders). This splitting provides a natural way of providing symmetrical beams for illumination in different directions using the same hardware as the wavelength compensation (e.g., to provide for simultaneous acquisition of +1 and -1 diffraction order from the target).

However a disadvantage of using a grating is that such an arrangement is light inefficient: a component of the light will be reflected by the grating, other components of may end up in undesired diffraction orders (e.g., diffraction orders other than the +1 and -1 orders).

Using an AOM/EOM/SLM or similar modulation element provides greater flexibility than using a grating. Instead of providing various gratings with different but fixed pitches, the modulation element may provide an effective grating with a programmable pitch. For example, for an AOM, an effective optical grating is created by a sound wave propagated through an optical material. Modulation elements such as AOMs have advantages over fixed gratings, which include:

- The pitch of the grating can be adjusted by adjusting the frequency of the sound wave (in the case of an AOM) or other methods appropriate to the modulator type.

- More space efficient than a grating wheel or similar.
- The light out-coupling efficiency can be very high, e.g., up to 90% into the desired diffraction orders.

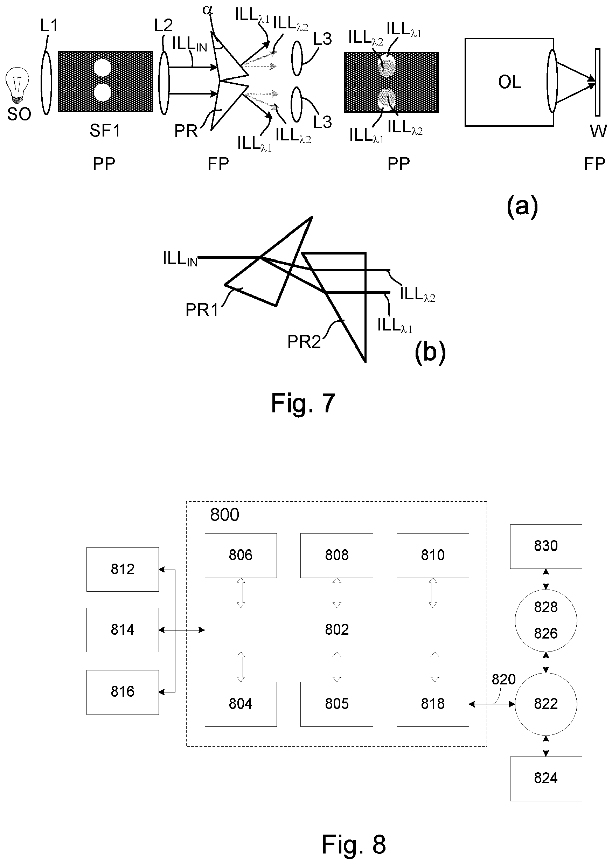

Figure 7(a) shows an equivalent representation to Figure 6(b) for an embodiment where the dispersive element comprises a prism (or pair of prisms) or another non-diffractive dispersive element made from dispersive material. Corresponding adaption of the metrology device illustrated by Figure 6(a) will be apparent and straightforward for the skilled person.

In this embodiment, two illumination pupils are generated, e.g., by providing two apertures in the spatial filter SF1. This provides illumination beams for simultaneous measurement in two measurement directions as with the previous embodiment (only one aperture is needed if the tool is configured for measurement in a single direction). The dispersive arrangement may comprise a prism PR or prism arrangement per illumination pupil and lens arrangements L3 (e.g., one per prism PR in order to create a pupil plane for each prism PR). Due to the dispersion of the prism PR, different wavelengths will deflect a different angles. The outgoing angle is determined by the angle of incidence of the input radiation $ILL_{IN}$ on the prism PR, the opening angle of the prism $\alpha$ and the dispersion of the prism material. Shown in the Figure are two illumination beams per direction, a first illumination beam $Ill_{\lambda 1}$ in a first position in pupil plane PP, corresponding to an input beam $ILL_{IN}$ of a first wavelength and a second illumination beam $Ill_{\lambda 2}$ in a second position in pupil plane PP, corresponding to an input beam $ILL_{IN}$ of a second wavelength. As no unwanted diffraction orders are generated, and the positions of the illumination beams vary continuously with wavelength, no second spatial filter is required at this plane (e.g., filter SF2 in Figure 6(a) is not required).

Although not shown, a tilt may be introduced in the second pupil plane after lens arrangements L3 to ensure that the two illumination beams overlap in the field plane. This can be done, for example, using two optical wedges in a similar manner to the imaging wedges often used in the dark field branch of a device such as illustrated in Figure 5(a) to image complementary diffraction orders simultaneously.

A higher dispersion can be obtained by providing for internal reflection within the prism PR, e.g., using an Abbe prism or similar element.

In order to match the dispersion to the target pitch, it is proposed that the prisms can be rotated to vary the angle of incidence of the input beam $ILL_{IN}$ (e.g., as provided via lens L2) onto its respective prism PR.

Other arrangements are possible. Figure 7(b) for example, shows a prism pair arrangement, where each beam path may comprise a prism pair (or pair of dispersive elements) PR1, PR2; i.e., a prism pair PR1 PR2 may replace each prism PR (and lens L3) in the arrangement of Figure 7(a). This results in a direct wavelength dependent displacement in the pupil plane (e.g., between illumination beam $Ill_{\lambda 1}$ of first wavelength and illumination beam $Ill_{\lambda 2}$ of a second wavelength) rather than an angular change. This negates the need for lens L3 (e.g., the dispersion arrangement comprises a pair of prisms per beam rather than a single prism per beam and a lens). Adjustment for target pitch in such an arrangement may comprise varying the distance between prism PR1 and PR2, and/or rotating the first prism PR1.

Such an arrangement has the advantage over the grating/modulator embodiments of being more light efficient and continuously tunable (not discrete). However, tuning for different target pitches is less straightforward. Also, dispersion of the prism (and other optical elements) requires configuration/engineering to match the dispersion of the overlay target over the full wavelength range.

Note that the arrangement described above show only an example of how such a system may be implemented, and different hardware setups are possible. It may even be that the illumination and the detection are not necessarily through the same lens, for example. Also the dispersive element may be located in the detection branch rather than the illumination branch to achieve the same goal of ensuring that the detected component(s) of interest are captured within the detection NA. As such, the dispersive element may be located to act on the captured component(s) of interest (e.g., diffraction orders), so as to displace them directly onto the detection NA.

The detection apertures are depicted as being circular in the above examples, but are not limited to such. A more elongated detection aperture is possible, in which the resolution and available angular space is balanced differently, for example.

Figure 8 is a block diagram that illustrates a computer system 800 that may assist in implementing the methods and flows disclosed herein. Computer system 800 includes a bus 802 or other communication mechanism for communicating information, and a processor 804 (or multiple processors 804 and 805) coupled with bus 802 for processing information. Computer system 800 also includes a main memory 806, such as a random access memory (RAM) or other dynamic storage device, coupled to bus 802 for storing information and instructions to be executed by processor 804. Main memory 806 also may be used for storing temporary variables or other intermediate information during execution of instructions to be executed by processor 804. Computer system 800 further includes a read only memory (ROM) 808 or other static storage device coupled to bus 802 for storing static information and instructions for processor 804. A storage device 810, such as a magnetic disk or optical disk, is provided and coupled to bus 802 for storing information and instructions.

Computer system 800 may be coupled via bus 802 to a display 812, such as a cathode ray tube (CRT) or flat panel or touch panel display for displaying information to a computer user. An input device 814, including alphanumeric and other keys, is coupled to bus 802 for communicating information and command selections to processor 804. Another type of user input device is cursor control 816, such as a mouse, a trackball, or cursor direction keys for communicating direction information and command selections to processor 804 and for controlling cursor movement on display 812. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 800 in response to processor 804 executing one or more sequences of one or more instructions contained in main memory 806. Such instructions may be read into main memory 806 from another computer-readable medium, such as storage device 810. Execution of the sequences of instructions contained in main memory 806 causes processor 804 to perform the process steps described herein. One or more processors in a multiprocessing arrangement may also be employed to execute the sequences of instructions contained in main memory 806. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 804 for execution. Such a medium may take many forms, including but not limited to, non-volatile media, volatile media, and transmission media. Non-volatile media include, for example, optical or magnetic disks, such as storage device 810. Volatile media include dynamic memory, such as main memory 806. Transmission media include coaxial cables, copper wire and fiber optics, including the wires that comprise bus 802. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 804 for execution. For example, the instructions may initially be borne on a magnetic disk of a remote computer. The remote computer can load the instructions into its dynamic memory and send the instructions over a telephone line using a modem. A modem local to computer system 800 can receive the data on the telephone line and use an infrared transmitter to convert the data to an infrared signal. An infrared detector coupled to bus 802 can receive the data carried in the infrared signal and place the data on bus 802. Bus 802 carries the data to main memory 806, from which processor 804 retrieves and executes the instructions. The instructions received by main memory 806 may optionally be stored on storage device 810 either before or after execution by processor 804.

Computer system 800 also preferably includes a communication interface 818 coupled to bus 802. Communication interface 818 provides a two-way data communication coupling to a network link 820 that is connected to a local network 822. For example, communication interface 818 may be an integrated services digital network (ISDN) card or a modem to provide a data communication connection to a corresponding type of telephone line. As another example, communication interface 818 may be a local area network (LAN) card to provide a data communication connection to a compatible LAN. Wireless links may also be implemented. In any such implementation, communication interface 818 sends and receives electrical, electromagnetic or optical signals that carry digital data streams representing various types of information.

Network link 820 typically provides data communication through one or more networks to other data devices. For example, network link 820 may provide a connection through local network 822 to a host computer 824 or to data equipment operated by an Internet Service Provider (ISP) 826. ISP 826 in turn provides data communication services through the worldwide packet data communication network, now commonly referred to as the "Internet" 828. Local network 822 and Internet 828 both use electrical, electromagnetic or optical signals that carry digital data streams. The signals through the various networks and the signals on network link 820 and through communication interface 818, which carry the digital data to and from computer system 800, are exemplary forms of carrier waves transporting the information.

Computer system 800 may send messages and receive data, including program code, through the network(s), network link 820, and communication interface 818. In the Internet example, a server 830 might transmit a requested code for an application program through Internet 828, ISP 826, local network 822 and communication interface 818. One such downloaded application may provide for one or more of the techniques described herein, for example. The received code may be executed by processor 804 as it is received, and/or stored in storage device 810, or other non-volatile storage for later execution. In this manner, computer system 800 may obtain application code in the form of a carrier wave.

Further embodiments are disclosed in the subsequent list of numbered clauses:

1. A metrology device operable to measure a sample with measurement radiation, the metrology device comprising:

an illumination branch operable to propagate measurement radiation to a sample;

a detection branch operable to propagate one or more components of scattered radiation, scattered from said sample as a result of illumination of the sample by said measurement radiation; and

a dispersive arrangement in either of said illumination branch or said detection branch, wherein said dispersive arrangement is arranged to maintain one or more components of said scattered radiation at substantially a same respective location in a detection pupil plane over a range of wavelength values for said measurement radiation.

2. A metrology device as defined in clause 1, wherein said dispersive arrangement comprises at least one passive dispersive element.

3. A metrology device as defined in clause 1 or 2, comprising a fixed detection aperture stop; said dispersive arrangement being arranged such that said one or more components of scattered radiation are maintained within at least one detection region defined by the fixed detection aperture stop.

4. A metrology device as defined in clause 3, wherein said one of one or more components of scattered radiation overfills said at least one detection region defined by the fixed detection aperture stop.

5. A metrology device as defined in clause 3 or 4, wherein the fixed detection aperture stop defines at least two separated detection regions in said detection pupil plane, for capturing a respective one of one or more components of scattered radiation.

6. A metrology device as defined in clause 5, comprising a separate illumination region corresponding to a respective one of each detection region, and wherein each illumination region is the same size or larger than its corresponding detection region.

7. A metrology device as defined in any preceding clause, wherein said one or more components of scattered radiation comprise at least a pair of complementary diffraction orders of the scattered radiation.

8. A metrology device as defined in any preceding clause, wherein said one or more components of scattered radiation comprise at least two pairs of complementary diffraction orders of the scattered radiation.

9. A metrology device as defined in any preceding clause, wherein said dispersive arrangement is configurable to substantially match the dispersion imposed by the sample.

10. A metrology device as defined in any preceding clause, wherein said dispersive arrangement is comprised within an illumination pupil plane of said illumination branch or a detection pupil plane of said detection branch.

11. A metrology device as defined in clause 10, wherein said illumination branch comprises a fixed intermediate illumination numerical aperture for providing input radiation; and

wherein said dispersive arrangement is arranged to receive said input radiation and generate at least one beam of said measurement radiation at a location in said illumination pupil plane which varies with said wavelength such that said one or more components of scattered radiation are maintained at substantially a same respective location in said detection pupil plane over said range of wavelength values.

12. A metrology device as defined in any preceding clause, wherein said dispersive arrangement comprises at least one diffractive optical element operable to generate at least one illumination diffraction order; and

said metrology device is operable to use said at least one illumination diffraction order as said measurement radiation.

13. A metrology device as defined in clause 12, wherein the diffractive optical element comprises a diffraction grating.

14. A metrology device as defined in clause 13, wherein said dispersive arrangement comprises a plurality of diffraction gratings having different pitches and arranged such that they can be individually switched into the illumination branch.

15. A metrology device as defined in clause 12, wherein the diffractive optical element comprises an adjustable pitch modulation element.

16. A metrology device as defined in clause 15, wherein the adjustable pitch modulation element comprises one of: an acousto-optical modulator, an electro-optical modulator or a spatial light modulator.

17. A metrology device as defined in any of clauses 12 to 16, wherein said diffractive optical element is operable to generate two complementary illumination diffraction orders; and

said metrology device is operable to use each of said two complementary illumination diffraction orders as a respective beam of measurement radiation of a pair of beams of measurement radiation for simultaneous measurement of the sample from two different directions.

18. A metrology device as defined in clause 11, wherein said dispersive arrangement comprises at least one non-diffractive dispersive element.

19. A metrology device as defined in clause 18, wherein said non-diffractive dispersive arrangement comprises one or more prisms.

20. A metrology device as defined in clause 19, wherein said one or more prisms comprises at least one prism per beam of measurement radiation.

21. A metrology device as defined in clause 18 or 19, wherein each of said prisms is configurable to vary an angle of incidence of said input illumination onto said prisms.

22. A metrology device as defined in any preceding clause, wherein said dispersive arrangement further comprises an optical element operable to translate any change in beam angle imposed by said diffractive optical element or non-diffractive optical element to a displacement in an illumination pupil plane or said detection pupil plane.

23. A metrology device as defined in clause 11, wherein said non-diffractive dispersive arrangement comprises one or more prism pairs, each prism pair being arranged in a beam displacement configuration.

24. A metrology device as defined in clause 23, wherein said one or more prism pairs comprises at least one prism pair per beam of measurement radiation.

25. A metrology device as defined in clause 23 or 24, wherein each of said prism pairs is configurable to vary an angle of incidence of said input illumination onto a first prism of said prism pair and/or vary a distance between the prisms of each prism pair.

26. A metrology device as defined in any preceding clause, wherein said measurement radiation comprises multimode radiation; or incoherent radiation or an approximation thereof.

27. A metrology device as defined in any preceding clause, comprising sensor optics for capturing said one or more components of scattered radiation.

28. A metrology device as defined in any preceding clause, comprising a substrate support for holding a substrate comprising one or more structures formed by a lithographic process.

29. A metrology device as defined in any preceding clause, wherein said range of wavelength values comprises a range having a lower bound of 200nm, 300nm or 400nm and a higher bound of 700nm, 800nm, 1500nm or 2000nm.

30. A method of measuring a sample with measurement radiation, the method comprising:

propagating measurement radiation to the sample;
capturing one or more components of scattered radiation, scattered from said sample as a result of illumination of the sample by said measurement radiation; and
dispersing said measurement radiation or said scattered radiation so as to maintain one or more components of said scattered radiation at substantially a same respective location in a detection pupil plane over a range of wavelength values for said measurement radiation.

31. A method as defined in clause 30, comprising passively dispersing said measurement radiation or said scattered radiation.

32. A method as defined in clause 30 or 31, wherein said dispersing is such that said one or more components of scattered radiation are maintained within at least one fixed detection region in said detection pupil plane .

33. A method as defined in clause 32, wherein the detection numerical aperture comprises at least two separated detection regions in said detection pupil plane, each detection region for capturing a respective one of said one or more components of scattered radiation.

34. A method as defined in clause 32 or 33, wherein said one of one or more components of scattered radiation overfills said detection numerical aperture.

35. A method as defined in any of clauses 30 to 34, wherein said one or more components of scattered radiation comprise at least a pair of complementary diffraction orders of the scattered radiation.

36. A method as defined in any of clauses 30 to 35, wherein said one or more components of scattered radiation comprise at least two pairs of complementary diffraction orders of the scattered radiation.

37. A method as defined in any of clauses 30 to 36, comprising configuring the dispersing to substantially match the dispersion imposed by the sample.

38. A method as defined in any of clauses 30 to 37, wherein said dispersing is performed within an illumination pupil plane or a detection pupil plane.

39. A method as defined in clause 38, comprising receiving input radiation and generating at least one beam of measurement radiation at a location in said illumination pupil plane which varies with said wavelength such that said one or more components of scattered radiation are maintained at substantially a same respective location in said detection pupil plane over said range of wavelength values.

40. A method as defined in any of clauses 30 to 39, wherein said dispersing comprises generating at least one illumination diffraction order; and
using said at least one illumination diffraction order as said measurement radiation.

41. A method as defined in clause 40, comprising using a diffractive optical element to generate said at least one illumination diffraction order .

42. A method as defined in clause 41, comprising matching a pitch of said diffractive optical element to a pitch of sample based on a magnification of the metrology device.

43. A method as defined in clause 41 or 42, wherein the diffractive optical element comprises a grating.

44. A method as defined in clause 41 or 42, wherein the diffractive optical element comprises an adjustable pitch modulation element.

45. A method as defined in clause 44, wherein the adjustable pitch modulation element comprises one of: an acousto-optical modulator, an electro-optical modulator or a spatial light modulator.

46. A method as defined in any of clauses 41 to 45, comprising using the diffractive optical element to generate two complementary illumination diffraction orders; and
using each of said two complementary illumination diffraction orders as a respective beam of measurement radiation of a pair of beams of measurement radiation for simultaneous measurement of the sample from two different directions.

47. A method as defined in clause 39, wherein said wherein said dispersing comprises using at least one non-diffractive dispersive element.

48. A method as defined in clause 47, wherein said non-diffractive dispersive arrangement comprises one or more prisms.

49. A method as defined in clause 48, wherein said one or more prisms comprises at least one prism per beam of measurement radiation.

50. A method as defined in clause 47 or 48, comprising varying an angle of incidence of said input illumination onto said prisms depending on a pitch of said sample.

51. A method as defined in any of clauses 30 to 50, further comprising translating any change in beam angle imposed by said diffractive optical element or non-diffractive optical element to a displacement in said illumination pupil plane or detection pupil plane.

52. A method as defined in clause 39, wherein said non-diffractive dispersive arrangement comprises one or more prism pairs, each prism pair being arranged in a beam displacement configuration.

53. A method as defined in clause 52, wherein said one or more prism pairs comprises at least one prism pair per beam of measurement radiation.

54. A method as defined in clause 52 or 53, comprising varying an angle of incidence of said input illumination onto a first prism of said prism pair and/or varying a distance between the prisms of each prism pair depending on a pitch of said sample.

55. A method as defined in any of clauses 30 to 54, wherein said measurement radiation comprises multimode radiation; or incoherent radiation or an approximation thereof.

56. A method as defined in any of clauses 30 to 55, comprising determining a complex-valued field to describe the sample from a measured amplitude profile obtained during a measurement of the sample.

57. A method as defined in clause 56, comprising correcting said complex-valued field for aberrations in a sensor used to capture the one or more components of scattered radiation.

58. A method as defined in any of clauses 30 to 57, wherein the sample comprises one or more structures formed by a lithographic process on a substrate.

59. A method as defined in any of clauses 30 to 58, wherein said range of wavelength values comprises a range having a lower bound of 200nm, 300nm or 400nm and a higher bound of 700nm, 800nm, 1500nm or 2000nm.60. A lithographic cell comprising a metrology device according to clause 1 to 29.

Note that, while the teachings herein have particular applicability to incoherent systems (due to the larger illumination NA of such systems), it is not so limited and the concepts disclosed herein are applicable to coherent and partially or near coherent systems.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.    A metrology device operable to measure a sample with measurement radiation, the metrology device comprising:

an illumination branch operable to propagate measurement radiation to a sample;
a detection branch operable to propagate one or more components of scattered radiation, scattered from said sample as a result of illumination of the sample by said measurement radiation; and
a dispersive arrangement in either of said illumination branch or said detection branch, wherein said dispersive arrangement is arranged to maintain one or more components of said scattered radiation at substantially a same respective location in a detection pupil plane over a range of wavelength values for said measurement radiation.

2.    A metrology device as claimed in claim 1, wherein said dispersive arrangement comprises at least one passive dispersive element.

3.    A metrology device as claimed in claim 1 or 2, comprising a fixed detection aperture stop; said dispersive arrangement being arranged such that said one or more components of scattered radiation are maintained within at least one detection region defined by the fixed detection aperture stop.

4.    A metrology device as claimed in claim 3, wherein said one of one or more components of scattered radiation overfills said at least one detection region defined by the fixed detection aperture stop.

5.    A metrology device as claimed in claim 3 or 4, wherein the fixed detection aperture stop defines at least two separated detection regions in said detection pupil plane, for capturing a respective one of one or more components of scattered radiation, and wherein, optionally, the metrology device comprises a separate illumination region corresponding to a respective one of each detection region, and wherein each illumination region is the same size or larger than its corresponding detection region.

6.    A metrology device as claimed in any preceding claim, wherein said one or more components of scattered radiation comprise at least a pair of complementary diffraction orders of the scattered radiation.

7.    A metrology device as claimed in any preceding claim, wherein said one or more components of scattered radiation comprise at least two pairs of complementary diffraction orders of the scattered radiation.

8.    A metrology device as claimed in any preceding claim, wherein said dispersive arrangement is configurable to substantially match the dispersion imposed by the sample.

9. A metrology device as claimed in any preceding claim, wherein said dispersive arrangement is comprised within an illumination pupil plane of said illumination branch or a detection pupil plane of said detection branch, and wherein, optionally, said illumination branch comprises a fixed intermediate illumination numerical aperture for providing input radiation; and

   wherein said dispersive arrangement is arranged to receive said input radiation and generate at least one beam of said measurement radiation at a location in said illumination pupil plane which varies with said wavelength such that said one or more components of scattered radiation are maintained at substantially a same respective location in said detection pupil plane over said range of wavelength values.

10. A metrology device as claimed in any preceding claim, wherein said dispersive arrangement comprises at least one diffractive optical element operable to generate at least one illumination diffraction order; and
    said metrology device is operable to use said at least one illumination diffraction order as said measurement radiation.

11. A metrology device as claimed in claim 10, wherein the diffractive optical element comprises at least one of:

    - a diffraction grating, wherein, optionally, said dispersive arrangement comprises a plurality of diffraction gratings having different pitches and arranged such that they can be individually switched into the illumination branch, and
    - the diffractive optical element comprises an adjustable pitch modulation element, and wherein, optionally, the adjustable pitch modulation element comprises one of: an acousto-optical modulator, an electro-optical modulator or a spatial light modulator.

12. A metrology device as claimed in any of claims 10 or 11, wherein said diffractive optical element is operable to generate two complementary illumination diffraction orders; and
    said metrology device is operable to use each of said two complementary illumination diffraction orders as a respective beam of measurement radiation of a pair of beams of measurement radiation for simultaneous measurement of the sample from two different directions.

13. A metrology device as claimed in any preceding claim, wherein said dispersive arrangement comprises at least one non-diffractive dispersive element, wherein, optionally, said non-diffractive dispersive arrangement comprises one or more prisms.

14. A metrology device as claimed in any preceding claim, wherein said dispersive arrangement further comprises an optical element operable to translate any change in beam angle imposed by said diffractive optical element or non-diffractive optical element to a displacement in an illumination pupil plane or said detection pupil plane.

15. A method of measuring a sample with measurement radiation, the method comprising:

    propagating measurement radiation to the sample;
    capturing one or more components of scattered radiation, scattered from said sample as a result of illumination of the sample by said measurement radiation; and
    dispersing said measurement radiation or said scattered radiation so as to maintain one or more components of said scattered radiation at substantially a same respective location in a detection pupil plane over a range of wavelength values for said measurement radiation.

Fig. 1

Fig. 2

Fig. 3

LA

SC1

SC3

CL

0

-1    +1

SC2

MT

SM1

2

5

10

4

PU

W

Fig. 4

I

6

Z

8

λ

X

Fig. 5

Fig. 6

Fig. 7

Fig. 8

Europäisches
Patentamt

European
Patent Office

Office européen
des brevets

# EUROPEAN SEARCH REPORT

Application Number

**EP 21 18 8484**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2020/057900 A1 (ASML NETHERLANDS BV [NL]) 26 March 2020 (2020-03-26) * paragraphs [0052] – [0054], [0068], [0069]; figure 2 * ----- | 1-15 | INV. G03F7/20 |
| A | US 10 067 426 B2 (ASML NETHERLANDS BV [NL]) 4 September 2018 (2018-09-04) * column 10, line 63 – column 11, line 30; figure 5 * ----- | 1-15 | |
| E | WO 2021/151754 A1 (ASML NETHERLANDS BV [NL]) 5 August 2021 (2021-08-05) * paragraphs [0051] – [0063]; figure 6 * ----- | 1-15 | |
| | | | **TECHNICAL FIELDS SEARCHED (IPC)** G03F |

The present search report has been drawn up for all claims

| Place of search | Date of completion of the search | Examiner |
|---|---|---|
| Munich | 27 January 2022 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 18 8484

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2022

| Patent document cited in search report | | Publication date | Patent family member(s) | | Publication date |
|---|---|---|---|---|---|
| WO 2020057900 | A1 | 26-03-2020 | CN | 112740109 A | 30-04-2021 |
| | | | EP | 3853666 A1 | 28-07-2021 |
| | | | JP | 2022500685 A | 04-01-2022 |
| | | | KR | 20210043661 A | 21-04-2021 |
| | | | NL | 2023709 A | 30-04-2020 |
| | | | TW | 202028874 A | 01-08-2020 |
| | | | WO | 2020057900 A1 | 26-03-2020 |
| US 10067426 | B2 | 04-09-2018 | CN | 109643068 A | 16-04-2019 |
| | | | KR | 20190040316 A | 17-04-2019 |
| | | | TW | 201818051 A | 16-05-2018 |
| | | | US | 2018059552 A1 | 01-03-2018 |
| | | | WO | 2018036828 A1 | 01-03-2018 |
| WO 2021151754 | A1 | 05-08-2021 | TW | 202135192 A | 16-09-2021 |
| | | | WO | 2021151754 A1 | 05-08-2021 |

EPO FORM P0459

For more details about this annex : see Official Journal of the European Patent Office, No. 12/82

**EP 4 124 911 A1**

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- EP 3480554 A
- EP 2019052658 W